# EUROPEAN PATENT APPLICATION

(11) **EP 1 995 121 A1**
(43) Date of publication of application: **26.11.2008**
(21) Application number: 07425299.0
(22) Date of filing: 21.05.2007
(51) Int. Cl.: B60R 16/023, H05K 5/00

(54) **Electronic control unit with deformable fastening tabs**

(71) Applicant: MAGNETI MARELLI POWERTRAIN S.p.A., 20011 Corbetta (IT)
(72) Inventor: Fino, Endrio, 10090 Romano Canavese (IT); Cicognati, Fulvio, 10023 Chieri (IT)
(74) Representative: Jorio, Paolo

(57) **Abstract**

Electronic control unit (1) having: a printed circuit board (2), which supports an electric circuit, a plurality of electric/electronic components (3) electrically connected to the electric circuit, and at least one connector (4) electrically connected to the electric circuit; and a housing (5), which contains the printed circuit board (2) and comprises a base (6) supporting the printed circuit board (2) at the bottom and a cover (7) closing the base (6) at the top; the base (6) is provided with a plurality of fastening seats (17) and the cover (7) is provided with a plurality of fastening tabs (18), each of which is arranged corresponding to a respective fastening seat (17), is initially flat and is suitable for being bent by at least 90° inside the respective fastening seat (17) and against the base (6) to fasten the cover (7) to the base (6).

## Description

### TECHNICAL FIELD

The present invention relates to an electronic control unit.
The present invention is advantageously applied to an electronic control unit for an internal combustion engine, to which the following description will explicitly refer without loss of generality.

### BACKGROUND ART

An electronic control unit for an internal combustion engine comprises a printed circuit board (PCB), which supports an electric circuit, a plurality of electric/electronic components electrically connected to the electric circuit, and at least one connector electrically connected to the electric circuit to connect the electronic control unit to the internal combustion engine wiring. The printed circuit board is contained in a housing, which comprises a base supporting the printed circuit board at the bottom and a cover which closes the base at the top.

Normally, to close the housing, the cover is fixed to the base by means of a plurality of fastening screws (or, more rarely, rivets). However, this solution increases assembly costs due to the need to manage the additional component consisting of the fastening screws, drill the cover, drill and thread the base and tighten the fastening screws.

The patent US5703754A1 describes the use of an adhesive to fix the cover to the base to avoid the use of fastening screws; this construction solution is inexpensive but, on the other hand, in the event of the need for repair, opening and above all re-closing of the cover is extremely complicated (because before applying the new adhesive, the old adhesive has to be eliminated by scraping). The patent US5233506A1 describes a slot-in system with elastically deformable flanges to fasten the cover to the base; this construction solution does not involve the use of fastening screws, but is costly.

### DISCLOSURE OF INVENTION

The object of the present invention is to provide an electronic control unit which is free from the drawbacks described above and, in particular, is easy and inexpensive to produce.

According to the present invention an electronic control unit is produced in accordance with the attached claims.

### BRIEF DESCRIPTION OF THE DRAWINGS

The present invention will now be described with reference to the accompanying drawings, which illustrate a non-limiting example of embodiment, in which:
- figure 1 is a perspective, exploded, schematic view, with parts removed for clarity, of an electronic control unit for an internal combustion engine produced in accordance with the present invention;
- figure 2 is a further perspective, exploded, schematic view, with parts removed for clarity, of the electronic control unit of figure 1;
- figure 3 is a lateral section view of the electronic control unit of figure 1;
- figure 4 is a view from below of the electronic control unit of figure 1; and
- figures 5 and 6 are two lateral section views of a fastening tab of the electronic control unit of figure 1 in an assembly configuration and a fastening configuration respectively.

### BEST MODE FOR CARRYING OUT THE INVENTION

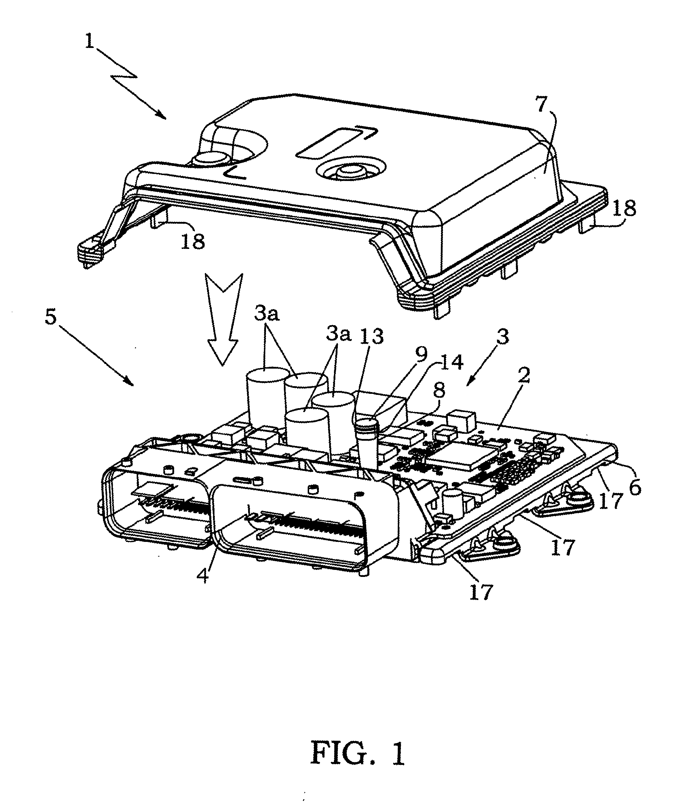

In figure 1, number 1 indicates overall an electronic control unit for an internal combustion engine.

The electronic control unit 1 comprises a printed circuit board 2, which supports an electric circuit, a plurality of electric/electronic components 3 electrically connected to the electric circuit, and a connector 4 electrically connected to the electric circuit to connect the electronic control unit 1 to the internal combustion engine wiring. In particular, the printed circuit board 2 supports four electrolytic capacitors 3a, which have a cylindrical shape and significant dimensions and weight.

Furthermore, the electronic control unit 1 comprises a housing 5, which has a rectangular shape, contains the printed circuit board 2 and comprises a base 6 which supports at the bottom the printed circuit board 2 and a cover 7 which closes the base 6 at the top. The base 6 of the housing 5, in addition to its natural containing and mechanical protection function, also provides for dissipation of the heat produced by the electric/electronic components 3. Consequently, the printed circuit board 2 is positioned in contact with the base 6 of the housing 5 and to increase the heat exchange between the lower surface of the printed circuit board 2 and the upper surface of the base 6 of the housing 5, a paste can be applied which is heat-conducting and electrically insulated.

According to a preferred embodiment, the base 6 and the cover 7 of the housing 5 are made of cold-pressed sheet aluminium; in the embodiment illustrated in the attached figures, the base 6 has a thickness of 2.5 mm and the cover 7 has a thickness of 1.5 mm.

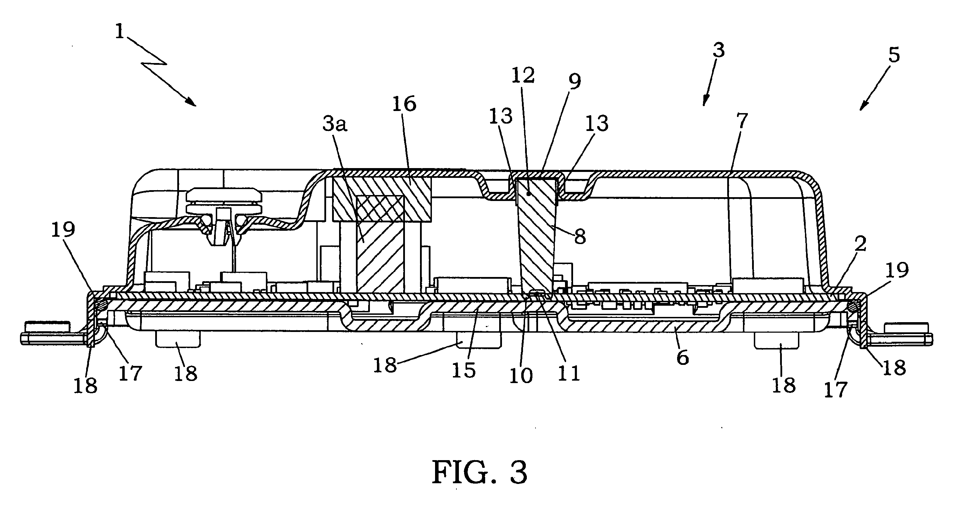

According to figure 3, to increase the heat exchange between the printed circuit board 2 and the base 6 of the housing 5, the printed circuit board 2 must be kept pressed with a certain force against the base 6 of the housing 5. For this purpose, the electronic control unit 1 comprises at least one pressure element 8 which is made of deformable elastic material, is arranged in a central position and is compressed between the cover 7 and the printed circuit board 2 to press-fit against the printed circuit board.

The pressure element 8 has a truncated cone shape with a larger base 9 resting on the cover 7 and a smaller base 10 resting on the printed circuit board 2. According to a possible embodiment illustrated in the attached figures, the smaller base 10 of the pressure element 8 resting on the printed circuit board 2 is rounded and has a central blind hole 11. The function of the central blind hole 11 is to give the smaller base 10 resting on the printed circuit board 2 a "suction cup" effect to increase the transverse retaining force.

According to a preferred embodiment illustrated in the attached figures, the cover 7 comprises an annular seat 12 which is cup-shaped and houses the larger base 9 of the pressure element 8 resting on the cover 7. To increase the retaining force of the pressure element 8 inside the seat 12, the pressure element 8 has two annular protrusions 13 which are sized to be press-fitted inside the seat 12. To further increase the retaining force of the pressure element 8 inside the seat 12, the larger base 9 of the pressure element 8 is fixed to the cover 7 by means of gluing, i.e. a drop of glue (resin) is applied in the seat 12 before forcing the larger base 9 of the pressure element 8 into the seat 12. Preferably, at the level of the larger base 9 the pressure element 8 is provided with two axial lateral channels 14 for discharge of the excess glue, i.e. the excess glue present inside the seat 12 can flow out of the seat 12 during forced insertion of the larger base 9 of the pressure element 8 via the two lateral channels 14.

According to a preferred embodiment, the pressure element 8 consists of silicone having, for example, a hardness equal to 80 ± 5 shoreA. In the embodiment illustrated in the attached figures, the pressure element 8 has an overall height of 27 mm, the larger base 9 has a diameter of 10 mm, the smaller base 10 has a diameter of 7 mm and the blind central hole 11 of the smaller base 10 has a diameter of 4 mm. Furthermore, in the embodiment illustrated in the attached figures, the pressure element 8 is compressed between the cover 7 and the printed circuit board 2 with a theoretical interference of 1.2 mm (more generally between 1 mm and 1.5 mm).

According to a preferred embodiment, the base 6 of the housing 5 has a counter surface 15, which is positioned at the level of the pressure element 8 and constitutes a support for the printed circuit board 2, providing a mechanical counter-action to the pressure element 8. In other words, without the counter surface 15 the printed circuit board 2 would sag in the middle due to the action of the pressure element 8.

According to a preferred embodiment, the printed circuit board 2 is without electric/electronic components 3 and welded parts in the area where the pressure element 8 rests in order to prevent any electric/electronic components 3 or welded parts being damaged over time by the pressure exerted by the pressure element 8.

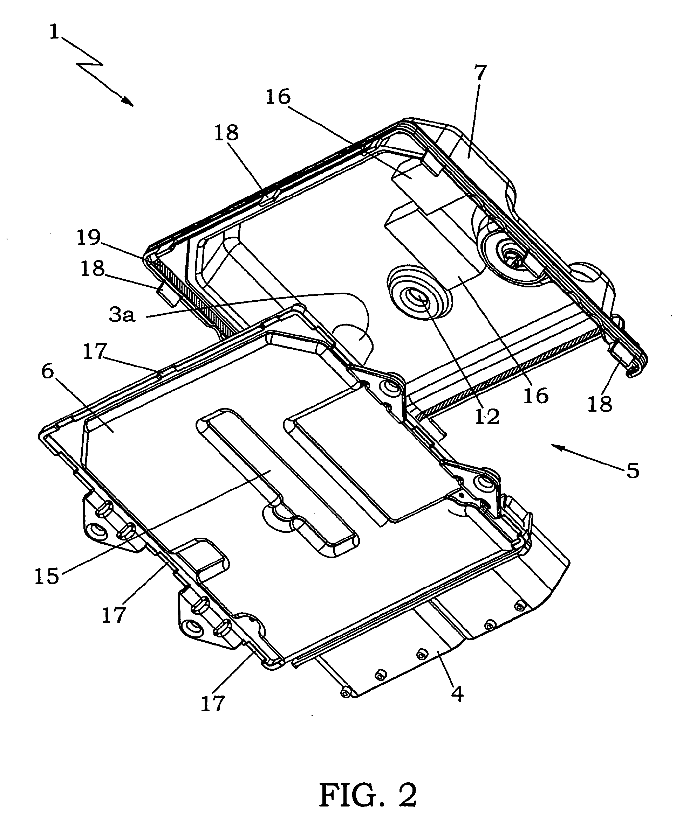

According to figures 2 and 3, the electronic control unit 1 comprises two blocks 16 made of foamed elastic deformable material, each of which is fixed (preferably glued) to an inner surface of the cover 7 in a position corresponding to the two respective electrolytic capacitors 3a, has a sufficient thickness to determine a vertical interference with the two respective electrolytic capacitors 3a so that it is compressed between the cover 7 and the electrolytic capacitors 3a, and has a larger area with respect to the electrolytic capacitors 3a in order to laterally envelop said electrolytic capacitors.

In other words, as each block 16 deforms, it envelops the respective electrolytic capacitors 3a at the top and at the side, contributing both to axial and lateral retention thereof. Due to the slight axial compression exerted by the blocks 16 on the electrolytic capacitors 3a, the latter are substantially exempt from significant vibration.

In the embodiment illustrated in the attached figures, each non-deformed block 16 has a thickness of 10 mm and an interference of approximately 5 mm with the electrolytic capacitors 3a.

According to a preferred embodiment, the blocks 16 consist of foamed open-cell material which has an optimal response to vibration. For example the blocks 16 can consist of foamed polyurethane resin with a PPI of 20 and an ISO 845 density of between 26 and 32 kg/m³.

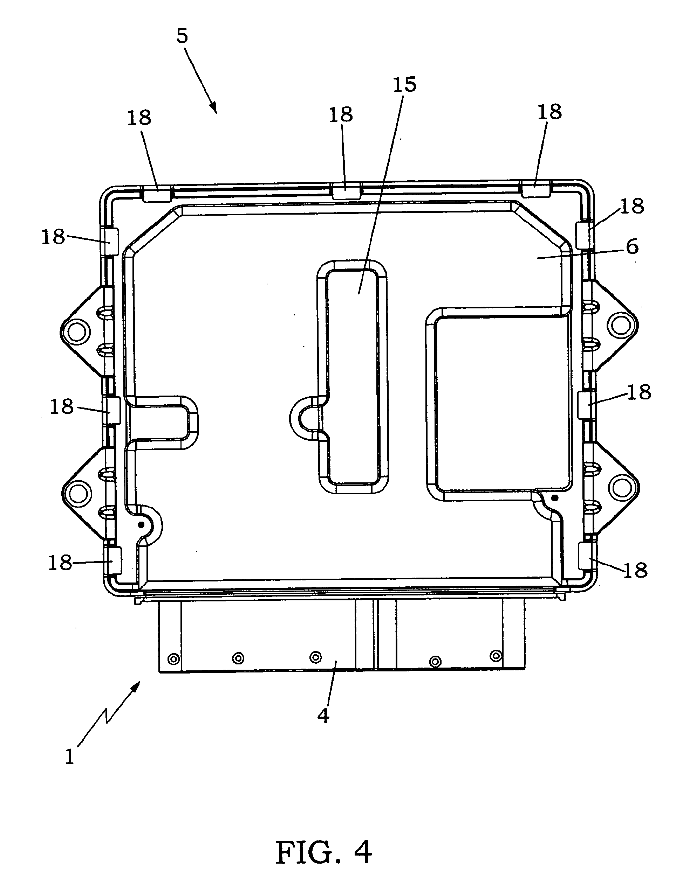

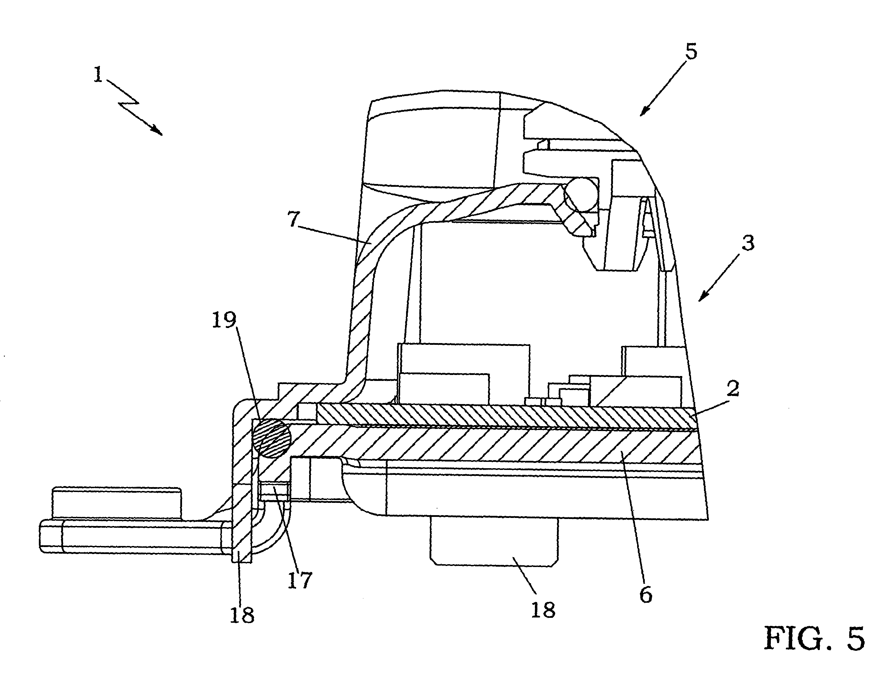

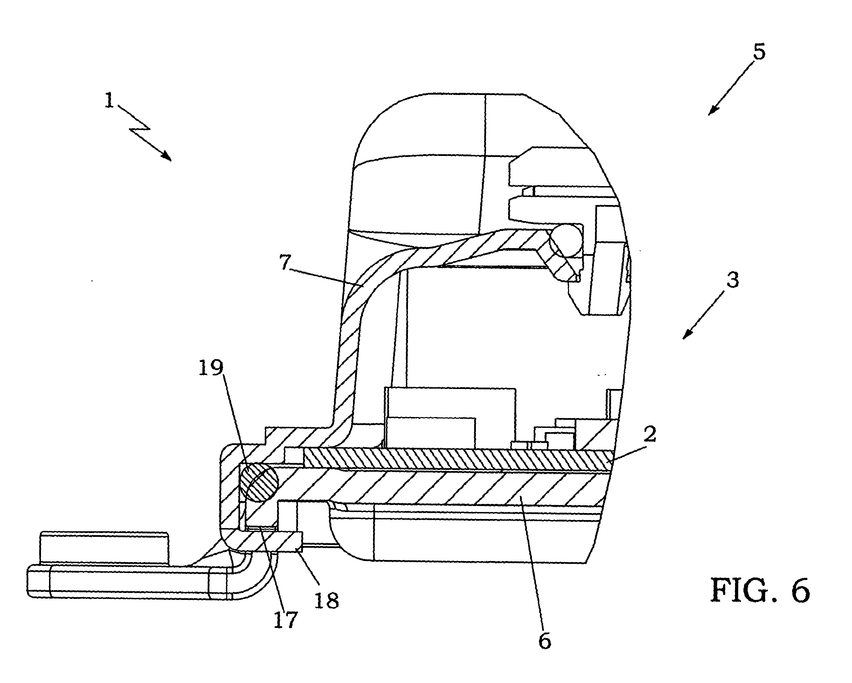

According to figures 2-6, the base 6 comprises a plurality of fastening seats 17 and the cover 7 comprises a plurality of fastening tabs 18, each positioned at the level of a respective fastening seat 17, is initially flat (figure 5) and is suitable for being bent by at least 90° inside the respective fastening seat 17 and against the base 6 to fasten the cover 7 to the base 6 (figure 6).

In other words, the cover 7 is fixed to the base 6 by means of the metallic fastening tabs 17, which are obtained from the same piece as the cover 7 (i.e. they form one single piece with the cover 7) and are plastically deformed (i.e. without subsequent elastic return) to accommodate the base 6; in this way it is possible to avoid the use of fastening screws.

According to a preferred embodiment, the fastening tabs 18 have a rectangular shape. Furthermore, in the embodiment illustrated in the attached figures, nine fastening tabs 18 are provided and nine fastening seats 17 symmetrically distributed in groups of three on three sides of the housing 5.

According to figures 3, 5 and 6, between the cover 7 and the base 6 a resin 19 is applied providing an adhesive gasket which, by polymerising after closing of the housing 5, adheres to the contact surfaces; the resin 19 is applied in a circular pattern and is subsequently compressed by closing of the housing 5, thus filling the free spaces.

The electronic control unit 1 described above has numerous advantages, as it is simple and inexpensive to produce and does not require screws or rivets to mechanically fasten the cover 7 to the base 6 as this function is performed by the fastening tabs 18. To perform a repair operation, simply force (break) the fastening tabs 18 so as to separate the cover 7 from the base 6; obviously a new cover 7 will then have to be used to re-close the housing 5 on the printed circuit board 2. The fact that the cover 7 has to be replaced every time the housing 5 is opened poses no particular problem, as repair operations are very rare and unauthorised opening of the housing 5 is prevented.

## Claims

1. Electronic control unit (1) comprising:
a printed circuit board (2), which supports an electric circuit, a plurality of electric/electronic components (3) electrically connected to the electric circuit, and at least one connector (4) electrically connected to the electric circuit; and
a housing (5), which contains the printed circuit board (2) and comprises a base (6) which supports the printed circuit board (2) at the bottom and a cover (7) which closes the base (6) at the top;
the electronic control unit (1) is **characterised in that**:
the base (6) comprising a plurality of fastening seats (17); and
the cover (7) comprising a plurality of fastening tabs (18), each of which is arranged at the level of a respective fastening seat (17), is initially flat, and is suitable for being bent by at least 90° inside the respective fastening seat (17) and against the base (6) to fasten the cover (7) to the base (6).

2. Electronic control unit (1) as claimed in claim 1, wherein the base (6) is made of sheet aluminium having a thickness of 2.5 mm and the cover (7) is made of sheet aluminium having a thickness of 1.5 mm.

3. Electronic control unit (1) as claimed in claim 1 or 2, wherein the fastening tabs (18) are made in one single piece with the cover (7).

4. Electronic control unit (1) as claimed in claim 1, 2 or 3, wherein the fastening tabs (18) have a rectangular shape.

5. Electronic control unit (1) as claimed in one of the claims from 1 to 4, wherein the housing (5) has a rectangular shape; nine fastening tabs (18) and nine fastening seats (17) are provided, distributed on three sides of the housing (5).
